(19) Europäisches Patentamt
European Patent Office
Office européen des brevets

(11) **EP 3 996 242 A1**

(12) **EUROPEAN PATENT APPLICATION**
published in accordance with Art. 153(4) EPC

(43) Date of publication:
**11.05.2022 Bulletin 2022/19**

(51) International Patent Classification (IPC):
**H02J 13/00** (2006.01) **H02J 3/38** (2006.01)
**F03D 17/00** (2016.01)

(21) Application number: **20835383.9**

(22) Date of filing: **26.06.2020**

(52) Cooperative Patent Classification (CPC):
**H02J 3/38; H02J 13/00;** F03D 17/00; Y02E 10/76;
Y02E 40/70; Y04S 10/12; Y04S 10/123

(86) International application number:
**PCT/JP2020/025218**

(87) International publication number:
**WO 2021/002289 (07.01.2021 Gazette 2021/01)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **04.07.2019 JP 2019124904**

(71) Applicant: **Hitachi, Ltd.**
**Tokyo 100-8280 (JP)**

(72) Inventors:
• **ABE, Masanori**
**Tokyo 100-8280 (JP)**
• **TOMOBE, Osamu**
**Tokyo 100-8280 (JP)**
• **KUMAGAI, Masatoshi**
**Tokyo 100-8280 (JP)**

(74) Representative: **MERH-IP Matias Erny Reichl
Hoffmann
Patentanwälte PartG mbB
Paul-Heyse-Strasse 29
80336 München (DE)**

(54) **DATA PROCESSING DEVICE, AND DATA PROCESSING METHOD**

(57) The objective of the present invention is to diagnose an abnormality in the amount of electricity generated by a distributed power source while restricting an increase in the number of sensors. A packet generating unit 200 generates electricity generation amount packet data D2a from electricity generation amount data D1 and identification data D6; an electricity generation feature quantity calculating unit 201 calculates electricity generation feature quantity data D3a, D3b indicating a feature quantity of the amount of electricity generated by each distributed power source, from each item of electricity generation amount packet data D2a, D2b; an abnormality diagnosing unit 202 calculates determination result data D5 from the electricity generation feature quantity data D3a, D3b on the basis of abnormality reference data D4; and a result output unit 203 consolidates abnormalities in the amounts of electricity generated by the distributed power sources, indicated by the determination result data D5, as abnormality diagnosis result data D7, and outputs the same to a display unit 206.

*FIG. 1*

EP 3 996 242 A1

**Description**

Technical Field

The present invention relates to a data processing device and a data processing method.

Background Art

In recent years, in order to achieve sustainable energy procurement and utilization as represented by the Sustainable Development Goals (SDGs), energy consumption is becoming renewable energy. Accordingly, when a power is generated by a distributed power supply such as a home, a non-kWh value of renewable energy such as a $CO_2$ reduction value and a regional contribution value is quantified separately from a value of a power to be a transaction product for improving a degree of achievement of renewable energy conversion of energy consumption in activities of companies and local governments. When a system that trades the non-kWh value of such renewable energy with other systems is constructed, it is important to guarantee the reliability of measured power generation amount data of the distributed power supply.

A method disclosed in PTL 1 is known as a method for guaranteeing the reliability of the measured data. PTL 1 discloses "a state determination method for at least three or more inertial sensors, the state determination method including performing state determination based on at least one of first mutual comparison processing of performing mutual comparison processing on an output value of one inertial sensor and output values of at least two or more other inertial sensors by using the output values of the inertial sensors, and second mutual comparison processing of performing mutual comparison processing and arithmetic value of the one inertial sensor and arithmetic values of the at least two or more other inertial sensors by using the arithmetic values based on the output values" as the method for guaranteeing reliability of measured data.

Citation List

Patent Literature

PTL 1: JP 2018-91738 A

Summary of Invention

Technical Problem

However, the method for guaranteeing the reliability of the data disclosed in PTL 1 needs to include a plurality of sensors for mutual determination, and since the number of sensors becomes redundant, an increase in facility cost of the distributed power supply is caused.

In a transaction market of the non-kWh value, it is difficult to collect smart meter data and verify a power generation amount due to a problem of a data amount and ownership, or the like. Further, in a power system monitoring system of the related art, since means for verifying correctness or incorrectness of a value by estimation based on power flow information of a power network is not provided, it is not possible to detect abnormal data.

The present invention has been made in view of the above circumstances, and an object of the present invention is to provide a data processing device and a data processing method capable of diagnosing an abnormality in a power generation amount of a distributed power supply while suppressing an increase in the number of sensors.

Solution to Problem

In order to achieve the above object, a data processing device according to a first aspect includes a feature value calculation unit which calculates feature values of power generation amounts of distributed power supplies, a diagnosis unit that compares feature values of power generation amounts of N (N is an integer of 2 or more) distributed power supplies based on positions of the N distributed power supplies and measurement times of the power generation amounts, and diagnoses an abnormality in the power generation amount of the distributed power supply based on a comparison result.

Advantageous Effects of Invention

According to the present invention, it is possible to diagnose the abnormality in the power generation amount of the distributed power supply while suppressing the increase in the number of sensors.

Brief Description of Drawings

[FIG. 1] FIG. 1 is a block diagram illustrating a functional configuration of a data processing device according to an embodiment.
[FIG. 2] FIG. 2 is a diagram illustrating an example of a data structure of power generation amount packet data of FIG. 1.
[FIG. 3] FIG. 3 is a diagram illustrating a numerical example of contents of the power generation amount packet data of FIG. 1.
[FIG. 4] FIG. 4 is a block diagram illustrating a hardware configuration example of the data processing device of FIG. 1 and a connection example with a distributed power supply.
[FIG. 5] FIG. 5 is a flowchart illustrating an example of entire processing in the data processing device of FIG. 1.
[FIG. 6] FIG. 6 is a flowchart illustrating an example of packet generation processing in FIG. 5.
[FIG. 7] FIG. 7 is a flowchart illustrating an example of feature value calculation processing of FIG. 5.
[FIG. 8] FIG. 8 is a diagram illustrating a numerical example during the feature value calculation.
[FIG. 9] FIG. 9 is a flowchart illustrating an example of abnormality determination processing of FIG. 5.
[FIG. 10] FIG. 10 is a diagram illustrating an example of a notification screen of a determination result displayed on a display unit of FIG. 1.

Description of Embodiments

An embodiment will be described with reference to the drawings. The embodiment to be described below does not limit inventions according to the claims, and all elements and combinations described in the embodiment are not essential for the solution of the invention.

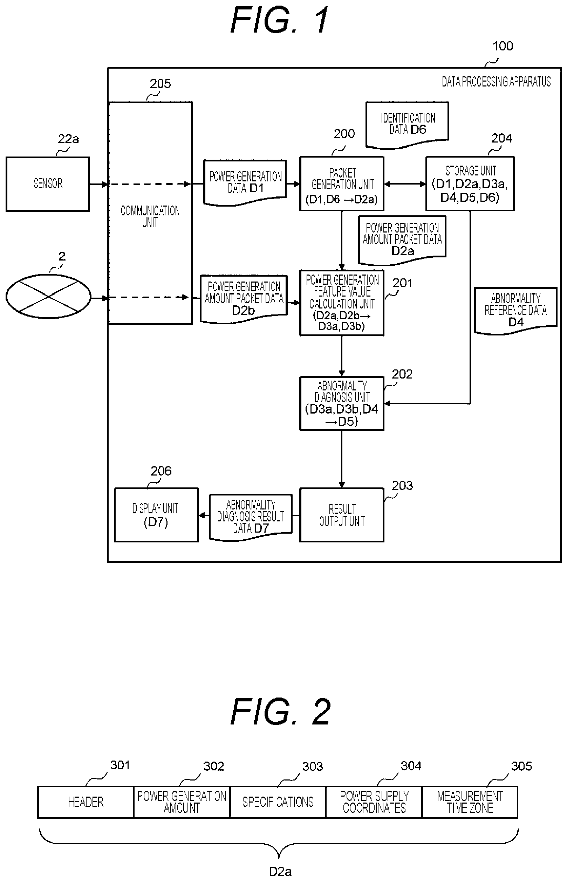

FIG. 1 is a block diagram illustrating a functional configuration of a data processing device according to a first embodiment.
In FIG. 1, a data processing device 100 compares feature values of power generation amounts of N (N is an integer of 2 or more) distributed power supplies based on positions of the N distributed power supplies and measurement times of the power generation amounts, and diagnoses an abnormality in the power generation amount of the distributed power supply based on the comparison result. The distributed power supply is, for example, a renewable energy power supply used for solar power generation, solar heat power generation, or wind power generation.
The feature values of the power generation amounts of the distributed power supplies are, for example, tendencies of changes in the power generation amounts of the distributed power supplies present within a predetermined range in the same time zone. The predetermined range in which the distributed power supplies are present can be set based on, for example, distances between the distributed power supplies, elevations in which the distributed power supplies are present, topographies in which the distributed power supplies are present, and the like.
At this time, for example, when wind power generation apparatuses are arranged close to each other on the sea, wind speeds and wind directions for the wind power generation apparatuses are substantially equal. Thus, when these wind power generation apparatuses are operating normally, the tendencies of the changes in the power generation amounts of these wind power generation apparatuses in the same time zone are substantially equal.
Thus, the data processing device 100 can monitor the tendencies of the changes in the power generation amounts of the distributed power supplies present within the predetermined range in the same time zone, and determine that the power generation amount of the distributed power supply is abnormal when there is the distributed power supply having a different tendency of the change in the power generation amount in the same time zone among the distributed power supplies present within the predetermined range.
Hereinafter, a configuration example of the data processing device 100 will be specifically described.
The data processing device 100 includes a packet generation unit 200, a power generation feature value calculation unit 201, an abnormality diagnosis unit 202, a result output unit 203, a storage unit 204, a communication unit 205, and a display unit 206. The data processing device 100 is connected to a sensor 22a and a communication network 2 via the communication unit 205.
The sensor 22a measures the power generation amount of the distributed power supply and inputs the power generation amount to the data processing device 100. The communication network 2 may be a wide area network (WAN) such as the Internet, a local area network (LAN) such as WiFi (registered trademark) or Ethernet (registered trademark), or a mixture of the WAN and the LAN.
The packet generation unit 200 generates power generation amount packet data D2a from power generation amount data D1 and identification data D6. The power generation amount data D1 is data regarding the power generation amount of the distributed power supply. The identification data D6 is data including the position of the distributed power supply and the measurement time of the power generation amount. The power generation amount packet data D2a is data in which the position of the distributed power supply and the measurement time of the power generation amount are added to the power generation amount data D1 and this data is processed into information that can be communicated via the communication network 2.

The power generation feature value calculation unit 201 acquires the power generation amount packet data D2a generated by the packet generation unit 200. Power generation amount packet data D2b transmitted via the communication network 2 is acquired via the communication unit 205. At this time, the pieces of power generation amount packet data D2a and D2b can indicate the power generation amounts measured in the same time zone of the different distributed power supplies present within the predetermined range. The power generation feature value calculation unit 201 calculates pieces of power generation feature value data D3a and D3b indicating the feature values of the power generation amounts of the distributed power supplies from the pieces of power generation amount packet data D2a and D2b.

The pieces of power generation feature value data D3a and D3b are, for example, pieces of data indicating characteristics of power generation such as a time-series rate of change in a power generation amount in a certain time zone. At this time, the pieces of power generation feature value data D3a and D3b can indicate the tendencies of the changes in the power generation amounts of the distributed power supplies present within the predetermined range in the same time zone. For example, when the power generation amount of each distributed power supply is determined by a natural phenomenon of a region such as a solar radiation amount of sunlight or an air amount, the pieces of power generation feature value data D3a and D3b can be used as pieces of information for comparing a degree of similarity between time characteristics of the power generation amounts of the distributed power supplies in the region.

The abnormality diagnosis unit 202 calculates determination result data D5 from the pieces of power generation feature value data D3a and D3b based on abnormality reference data D4. For example, the abnormality diagnosis unit 202 compares the pieces of power generation feature value data D3a and D3b between the distributed power supplies, determines an abnormality in the power generation amount of the distributed power supply based on whether or not an index value of the similarity determination calculated by the comparison exceeds the abnormality reference data D4, and outputs the determination result of the abnormality as the determination result data D5.

The abnormality reference data D4 is a threshold value as a reference for determining whether a value calculated by comparing the feature values is abnormal or normal. For example, in a case where the rates of change in the power generation amounts are used as the feature values and a difference is obtained between the rates of change in the power generation amounts of two distributed power supplies, it is possible to detect an abnormality in the power generation amount of the distributed power supply by determining that the difference is abnormal when an absolute value of the difference is equal to or larger than a threshold value and the difference is normal when the absolute value is smaller than the threshold value.

Based on a simulation, a statistical distribution of differences can be calculated for a parameter such as a distance, latitude and longitude, and the threshold value can be set to several times (for example, 1.1 times) a variance or a standard deviation in the statistical distribution. Alternatively, a relationship between a characteristic value such as a mountain shadow and a difference value may be estimated by applying a technique such as statistical analysis or machine learning, and the data processing device 100 may read a topography from a map of open data via the Internet and may calculate the threshold value. The feature value may be, for example, a ratio between a rated power generation amount and a power generation amount at a certain time.

The determination result data D5 is data indicating whether or not measurement data regarding the power generation amount of the distributed power supply is in an abnormal state having a value different from an actual value.

The result output unit 203 aggregates, as abnormality diagnosis result data D7, an abnormality in the power generation amount of the distributed power supply indicated by the determination result data D5, and outputs the abnormality to the display unit 206. The display unit 206 displays the abnormality diagnosis result data D7 output from the result output unit 203.

The storage unit 204 stores various kinds of data including input data and programs. At this time, the storage unit 204 can store the power generation amount data D1, the power generation amount packet data D2a, the power generation feature value data D3a, the abnormality reference data D4, the determination result data D5, and the identification data D6.

The communication unit 205 receives the power generation amount data D1 of the distributed power supply in which the sensor 22a is installed and the power generation amount packet data D2b of another distributed power supply, and transmits the power generation amount packet data D2a generated by the packet generation unit 200 to the communication network 2.

The data processing device 100 generates the power generation amount packet data D2a in which the identification data D6 such as the position of the distributed power supply and the measurement time of the power generation amount is added to the power generation amount data D1 regarding the power generation amount of the distributed power supply. The data processing device 100 acquires the power generation amount packet data D2b of another distributed power supply in the vicinity thereof via the communication network 2. The data processing device 100 calculates the pieces of power generation feature value data D3a and D3b for the pieces of power generation amount packet data D2a and D2b regarding the distributed power supply in which the sensor 22a is installed and the other distributed power supply in the vicinity thereof, respectively. The data processing device 100 calculates the determination result data D5 as to whether or not there is an abnormality in the power generation amount of the distributed power supply by comparing similarity between the power generation amounts of the plurality of distributed power supplies from the pieces of power generation feature value data D3a and D3b based on the abnormality reference data D4, and displays the abnormality diagnosis result data D7 of the power generation amount indicated by the determination result data D5.

Accordingly, it is possible to detect an abnormal tendency of the power generation amount based on the similarity between pieces of sensor data of the plurality of distributed power supplies, and it is possible to improve reliability of non-kWh value transaction data even when it is difficult to compare and verify the redundant transaction data by the sensor.

For example, the data processing device 100 can be applied to a distributed power supply that cooperates with an electronic transaction system of a non-kWh value. Accordingly, when a system that trades the non-kWh value of renewable energy with other systems is constructed, it is possible to guarantee the reliability of the measured power generation amount data of the distributed power supply.

FIG. 2 is a diagram illustrating an example of a data structure of the power generation amount packet data of FIG. 1.

In FIG. 2, the power generation amount packet data D2a includes data of a header 301, a power generation amount 302, specifications 303, power supply coordinates 304, and a measurement time zone 305. The power generation amount packet data D2b of FIG. 1 can also have a data structure similar to that of the power generation amount packet data D2a.

The header 301 includes information such as a communication destination and a protocol. The power generation amount 302 includes information such as a power generation amount based on the power generation amount data D1 and a measurement unit (for example, Wh, kWh, or the like). The power generation amount 302 is measured by the sensor 22a installed in the distributed power supply, and is output as the power generation amount data D1 from the sensor 22a.

The specifications 303 include characteristics as a facility of a distributed power supply, such as a rated capacity of the distributed power supply and a model number of a power conditioning system (PCS) used for the distributed power supply. The power supply coordinates 304 include information on an installation position of the distributed power supply. The measurement time zone 305 includes information on a date and time when the power generation amount is measured. The installation position of the distributed power supply may be registered in advance in the data processing device 100, or may be acquired from a global positioning system (GPS).

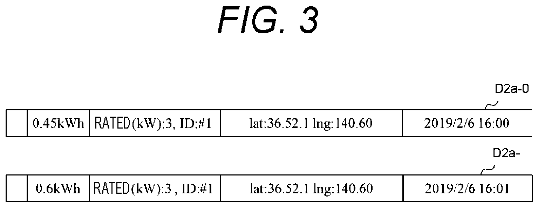

FIG. 3 is a diagram illustrating a numerical example of contents of the power generation amount packet data of FIG. 2.

In FIG. 3, pieces of power generation amount packet data D2a-0 and D2a-1 indicate cases where the measurement times on the same date are 16:00 and 16:01 for the distributed power supply at the same position. At this time, the pieces of power generation amount packet data D2a-0 and D2a-1 indicate that the power generation amount of the distributed power supply has changed from 0.45 kWh to 0.6 kWh.

The data processing device 100 of FIG. 1 may include one or more computers. For example, when the computer has a display device and the computer displays information on the display device, the computer may be the data processing device 100.

A case where the computer in the data processing device 100 "displays information for display" may be a case where the computer displays the information for display on the display device included in the computer, or may be a case where the computer transmits the information for display to a computer for display (in the latter case, the information for display is displayed by the computer for display).

The data processing device 100 may include an interface device unit, a storage unit, and a processor unit connected thereto. The data processing device 100 may be a software-defined device or a virtual device provided based on a computer resource pool (for example, an interface device unit, a storage unit, and a processor unit) such as a cloud infrastructure.

The "interface device unit" may be one or more interface devices. The one or more interface devices may be any of the following interface devices.

- An input and output (I/O) interface device for at least one of an I/O device and a remote terminal computer. An I/O interface device for the computer for display may be a communication interface device. The at least one I/O device may be either a user interface device, for example, an input device such as a keyboard and a pointing device, or an output device such as a display device.

- One or more communication interface devices. The one or more communications interface devices may be one or more communications interface devices of the same type (for example, one or more network interface cards (NIC)), or may be two or more communications interface devices of different types (for example, an NIC and a host bus adapter (HBA)).

The "storage unit" may be at least a memory unit of the memory unit and the storage unit. The "memory unit" is one or more memories, and may typically be a main storage device. At least one memory of the memory unit may be a volatile memory, or may be a nonvolatile memory.

The "storage unit" is one or more storages, and may typically be an auxiliary storage device. The "storage" means a physical storage device, and is typically a nonvolatile storage device, for example, a hard disk drive (HDD) or a solid state drive (SSD).

The "processor unit" is one or more processors. At least one processor is typically a microprocessor such as a central processing unit (CPU), but may be another type of processor such as a graphics processing unit (GPU) . At least one processor may be a single-core processor, or may be a multi-core processor. At least one processor may be a processor in a broad sense such as a hardware circuit (for example, a field-programmable gate array (FPGA) or an application specific integrated circuit (ASIC)) that performs part or all of the processing.

In FIG. 1, although functions have been described in terms of "kkk units" (excluding the interface device unit, the storage unit, and the processor unit), one or more computer programs may be realized by being executed by the processor unit, or may be realized by one or more hardware circuits (for example, FPGA or ASIC). When the function is realized by the program being executed by the processor unit, since predetermined processing is performed while appropriately using the storage unit and/or the interface device unit, the function may be at least a part of the processor unit. The processing described with the function as a subject may be processing performed by the processor unit or a device including the processor unit. The description of each function is an example, and a plurality of functions may be combined into one function, or one function may be divided into a plurality of functions.

A "data set" is a cluster of logical electronic data viewed from a program such as an application program, and may be, for example, any of a record, a file, a key value pair, and a tuple. A data format may be, for example, a data exchange format such as JavaScript (registered trademark) Object Notation (JSON) in which a human can easily read and write and a machine can easily parse and generate data.

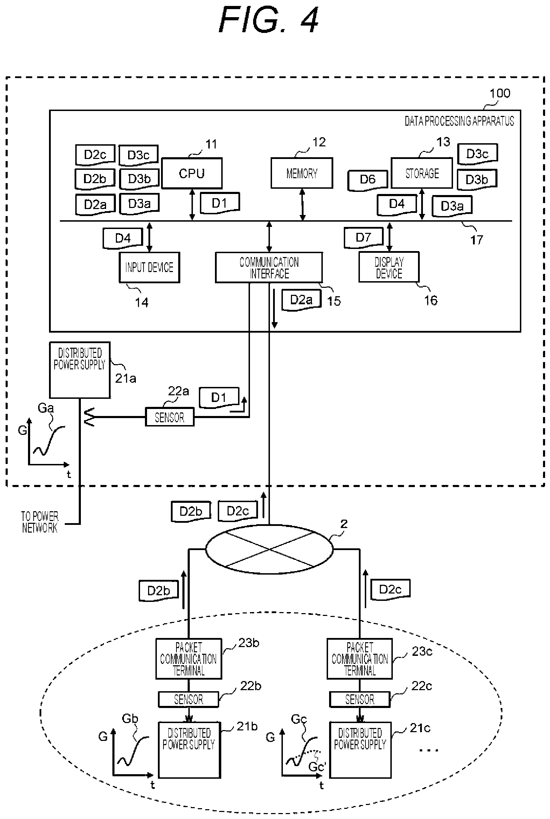

FIG. 4 is a block diagram illustrating a hardware configuration example of the data processing device of FIG. 1 and a connection example with the distributed power supply.

In FIG. 4, the data processing device 100 is realized by, for example, a computer (and peripheral devices thereof) such as a general-purpose computer or a server. The data processing device 100 includes a CPU 11, a memory 12, a storage 13, an input device 14, a communication interface device 15, and a display device 16. The CPU 11, the memory 12, the storage 13, the input device 14, the communication interface device 15, and the display device 16 are connected via a bus 17. The communication interface device 15 is connected to the sensor 22a and is connected to packet communication terminals 23b and 23c via the communication network 2.

The sensor 22a measures a power generation amount of a distributed power supply 21a and outputs, as the power generation amount data D1, the power generation amount to the data processing device 100. The distributed power supply 21a is connected to a power network. A sensor 22b measures a power generation amount of a distributed power supply 21b and outputs the power generation amount to the packet communication terminal 23b. A sensor 22c measures a power generation amount of a distributed power supply 21c and outputs the power generation amount to the packet communication terminal 23c.

The packet communication terminal 23b adds a position of the distributed power supply 21b and a measurement time of the power generation amount to the power generation amount data of the distributed power supply 21b, and transmits the data to the data processing device 100 via the communication network 2. The packet communication terminal 23c adds a position of the distributed power supply 21c and a measurement time of the power generation amount to the power generation amount data of the distributed power supply 21c, and transmits the data to the data processing device 100 via the communication network 2.

The CPU 11 realizes tasks of processing of the packet generation unit 200, the power generation feature value calculation unit 201, the abnormality diagnosis unit 202, and the result output unit 203 in FIG. 1 by reading and executing one or more programs stored in the storage 13.

An arithmetic processing device including one or a plurality of semiconductor chips may be adopted instead of the CPU 11. The program executed by the CPU 11 may be installed from a program source or may be incorporated as firmware in the data processing device 100. The program source may be, for example, a program distribution computer or a computer-readable recording medium (for example, a non-transitory recording medium).

The memory 12 is, for example, a random access memory (RAM), and temporarily stores a program read from the storage 13, a data set in an arithmetic process by the CPU 11, and the like.

The storage 13 is, for example, a hard disk drive (HDD) or a solid state drive (SSD), and stores a program executed by the CPU 11, various data sets in the data processing device 100, and the like.

The input device 14 is, for example, at least one of a keyboard switch, a pointing device such as a mouse, a touch panel, a voice instruction device, a non-contact type input device by detection of movement of a line of sight and blinking, or the like, and inputs a data set to the data processing device 100 according to an operation by a user. Here, the abnormality reference data D4 is input to the data processing device 100 via the input device 14 and is stored in the storage 13.

The communication interface device 15 is hardware having a function of controlling communication with the outside. The communication interface device 15 receives the power generation amount data D1 of the distributed power supply 21a transmitted from the sensor 22a, receives the pieces of power generation amount packet data D2b and D2c of the other distributed power supplies 21b and 21c, and simultaneously transmits the power generation amount packet data D2a generated by the data processing device 100 to the other distributed power supplies.

The display device 16 is, for example, a display or a printer, and displays a screen or the like for a user operation in the data processing device 100 or displays the abnormality diagnosis result data D7.

The CPU 11 is an example of the processor unit. The memory 12 and the storage 13 are examples of the storage unit. The communication interface device 15 is an example of the interface device unit.

The CPU 11 generates power generation amount packet data D2a in which identification data D6 including information such as a time and a position is added to the power generation amount data D1 regarding the power generation amount of the distributed power supply 21a. The CPU 11 acquires the pieces of power generation amount packet data D2b and D2c regarding the power generation amounts of the other distributed power supplies 23b and 23c in the vicinity of the distributed power supply 21a via the communication interface device 15. The CPU 11 calculates pieces of power generation feature value data D3a to D3c for the power generation amount packet data D2a regarding the power generation amount of the distributed power supply 21a and the pieces of power generation amount packet data D2b and D2c regarding the power generation amounts of the distributed power supplies 23b and 23c, respectively. The CPU 11 calculates the determination result data D5 indicating whether or not there is an abnormality in the power generation amounts of the distributed power supplies 21a to 21c by comparing the similarity between the power generation amounts of the plurality of distributed power supplies 21a to 21c from the pieces of power generation feature value data D3a to D3c based on the abnormality reference data D4, and displays the abnormality diagnosis result data D7 of the power generation amount indicated by the determination result data D5 on the display device 16.

For example, it is assumed that the distributed power supplies 21a to 21c are installed within a predetermined range in which power generation environments are similar. In this case, when the distributed power supplies 21a to 21c are operating normally, tendencies Ga to Gc of changes in power generation amounts G of the distributed power supplies 21a to 21c with the lapse of time t in the same time zone are substantially equal.

Thus, the CPU 11 can confirm that the distributed power supplies 21a to 21c are normally operating by extracting, as the pieces of power generation feature value data D3a to D3c, the tendencies Ga to Gc of the changes in the power generation amounts G of the distributed power supplies 21a to 21c with the lapse of time t in the same time zone from the pieces of power generation amount packet data D2a to D2c and comparing the tendencies Ga to Gc.

On the other hand, for example, it is assumed that there is an abnormality in the power generation amount G of the distributed power supply 21c. At this time, a tendency Gc' of a change in the power generation amount G of the distributed power supply 21c in the same time zone with the lapse of time t is different from the tendency Gc of the change when there is no abnormality in the power generation amount G of the distributed power supply 21c.

Thus, the CPU 11 extracts, as the pieces of power generation feature value data D3a to D3c, the tendencies Ga, Gb, and Gc' of changes in the power generation amounts G of the distributed power supplies 21a to 21c with the lapse of time t in the same time zone from the pieces of power generation amount packet data D2a to D2c, and compares the tendencies Ga, Gb, and Gc'. At this time, for example, the CPU 11 determines the similarity between the tendencies Ga, Gb, and Gc' of the changes based on the abnormality reference data D4. Although the tendencies Ga and Gb of the changes in the power generation amounts of the distributed power supplies 21a and 21b are similar to each other, when it is determined that the tendency Gc' of the change in the power generation amount of the distributed power supply 21c is not similar to the tendencies Ga and Gb of the changes in the power generation amounts of the distributed power supplies 21a and 21b, it can be diagnosed that there is an abnormality in the power generation amount of the distributed power supply 21c.

At this time, for example, when which distributed power supply has an abnormality in the power generation amount is specified based on the feature values of the power generation amounts of the plurality of distributed power supplies, the feature values of the power generation amounts of three or more distributed power supplies may be compared, and the distributed power supply having an abnormality in the power generation amount may be specified based on the majority rule method.

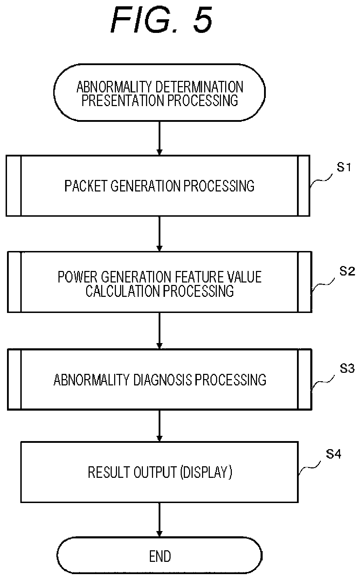

FIG. 5 is a flowchart illustrating an example of entire processing in the data processing device of FIG. 1.

In S1 of FIG. 5, the packet generation unit 200 of FIG. 1 performs the packet generation processing by using the power generation amount data D1 and the identification data D6. Accordingly, the power generation amount packet data D2a is generated.

Subsequently, in S2, the power generation feature value calculation unit 201 performs power generation feature value calculation processing on the power generation amount packet data D2a generated by the packet generation unit 200 and the power generation amount packet data D2b transmitted via the communication network 2. Accordingly, the pieces of power generation feature value data D3a and D3b are generated.

Subsequently, in S3, the abnormality diagnosis unit 202 performs abnormality determination processing based on the pieces of power generation feature value data D3a and D3b and the abnormality reference data D4. Accordingly, the determination result data D5 is generated.

Subsequently, in S4, the result output unit 203 outputs the abnormality determination result data D7 indicated by the determination result data D5 and displays the abnormality determination result data on the display unit 205.

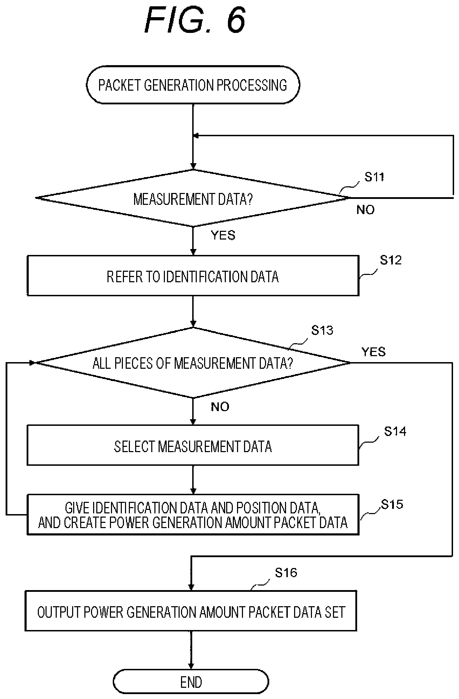

FIG. 6 is a flowchart illustrating an example of packet generation processing in FIG. 5.

In S11 of FIG. 6, the packet generation unit 200 of FIG. 1 determines whether or not the power generation amount data D1 is already obtained. The processing proceeds to S12 when the packet generation unit 200 obtains the power generation amount data D1 (YES in S12), and returns to S11 when the packet generation unit does not obtain the power generation amount data D1 (NO in S12).

Subsequently, in S12, the packet generation unit 200 reads the identification data D6 from the storage 13 in FIG. 3 to the memory 12, for example.

Subsequently, in S13, the packet generation unit 200 determines whether or not the pieces of power generation amount packet data D2a are created for all the pieces of power generation amount data D1. When the packet generation unit 200 creates the power generation amount packet data D2a for all the pieces of power generation amount data D1 (S13: YES), the processing proceeds to S16. When the packet generation unit 200 does not create the pieces of power generation amount packet data D2a for all the pieces of power generation amount data D1 (S13: NO), the processing proceeds to S14.

Subsequently, in S14, the packet generation unit 200 selects, as the power generation amount data D1, any measurement data for which the power generation amount packet data D2a is not generated.

Subsequently, in S15, the packet generation unit 200 assigns the identification data D6 to the power generation amount data D1 selected in S14, and creates the power generation amount packet data D2a, and the processing returns to S13.

Subsequently, in S16, the packet generation unit 200 outputs a power generation amount packet data set in which the pieces of power generation amount packet data D2a for a plurality of pieces of measurement data are set, and inputs the power generation amount packet data set to the power generation feature value calculation unit 201. The power generation amount packet data set is, for example, data obtained by setting packet data D2a indicating power generation amounts of the distributed power supply 21a at a plurality of measurement times in FIG. 4.

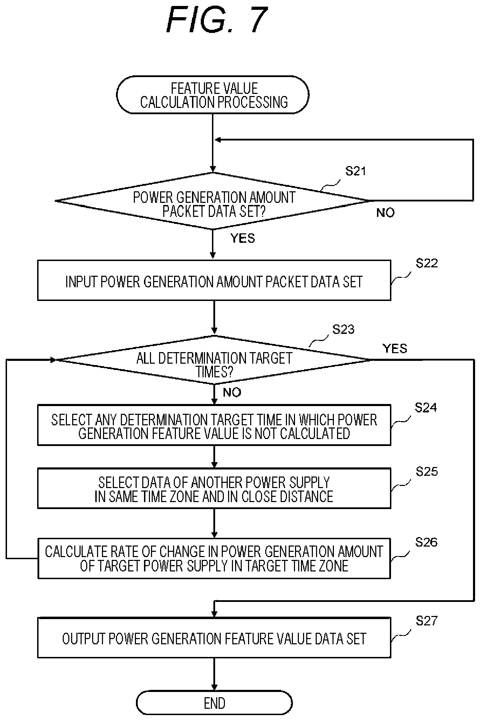

FIG. 7 is a flowchart illustrating an example of feature value calculation processing of FIG. 5.

In S21 of FIG. 7, the power generation feature value calculation unit 201 of FIG. 1 determines whether or not the power generation amount packet data set of the plurality of distributed power supplies are already obtained. The power generation amount packet data set of the plurality of distributed power supplies is, for example, power generation amount packet data D2a indicating the power generation amounts of the distributed power supply 21a in FIG. 4 at the plurality of measurement times, power generation amount packet data D2b indicating power generation amounts of the distributed power supply 21b at a plurality of measurement times, and power generation amount packet data D2c indicating power generation amounts of the distributed power supply 21c at a plurality of measurement times. The processing returns to S21 when the power generation feature value calculation unit 201 does not already obtain the power generation amount packet data set (S21: NO), and proceeds to S22 when the power generation feature value calculation unit already obtains the power generation amount packet data set (S21: YES).

Subsequently, in S22, the power generation feature value calculation unit 201 reads the power generation amount packet data set from the storage 13 of FIG. 4 to the memory 12, for example.

Subsequently, in S23, the power generation feature value calculation unit 201 determines whether or not the feature values are calculated for all determination target times. When the power generation feature value calculation unit 201 calculates the power generation feature values for all the determination target times (S23: YES), the processing proceeds to S27. The power generation feature values are feature values of the power generation amounts of the distributed power supplies. When the power generation feature value calculation unit 201 does not calculate the power generation feature value for all the determination target times (S23: NO), the processing proceeds to S24.

Subsequently, in S24, the power generation feature value calculation unit 201 selects any determination target time for which the power generation feature value is not calculated.

Subsequently, in S25, the power generation feature value calculation unit 201 selects data of another distributed power supply in the same time zone and in a short distance for the determination target time selected in S24.

Subsequently, in S26, a rate of change in a power generation amount of a target power supply in a target time zone is calculated as the power generation feature value of the distributed power supply selected in S25.

When the rate of change in the power generation amount is used as the power generation feature value, a power generation feature value $\alpha$ can be calculated by using the following Equation (1).

$$\alpha = \Delta P/\Delta T = (P_{t2} - P_{t1})/(t_2 - t_1) \quad ... \quad (1)$$

In Equation (1), $P_{t1}$ and $P_{t2}$ are standardized power generation amounts at certain times $t_1$ and $t_2$, and are ratios of power generation amounts to rated power generation amounts at measurement time intervals. However, the rated power generation amount is a power generation amount (unit: kWh) when it is assumed that power is generated at a constant rated output Pr (unit: kW) during the measurement time interval. $\Delta T$ is a difference value between two time cross-sections for comparing the rates of change in the power generation amounts. The standardized power generation amounts are used, and thus, the rates in change can be compared even when the plurality of distributed power supplies having different facility capacities are selected as the distributed power supplies present in a short distance.

Subsequently, in S27, the power generation feature value calculation unit 201 creates a power generation feature value data set indicating the power generation feature values of the plurality of distributed power supplies at each determination target time, and outputs the power generation feature value data set to the abnormality diagnosis unit 202.

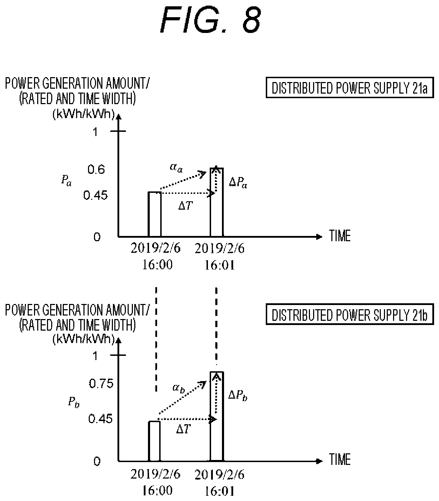

FIG. 8 is a diagram illustrating a numerical example during the feature value calculation.

FIG. 8 illustrates standardized power generation amounts $P_a$ and $P_b$ calculated from the pieces of power generation amount packet data D2a and D2b at 16:00 on February 6, 2019 and 16:01 on February 6, 2019 for the distributed power supply 21a cooperating with the data processing device 100 of FIG. 4 and another external distributed power supply 21b.

It is assumed that the rates of change in the power generation amounts are used as the power generation feature values of the distributed power supplies 21a and 21b. At this time, from Equation (1), a power generation feature value $\alpha_a$ of the distributed power supply 21a is calculated as $\alpha_a = \Delta P_a/\Delta T = 0.15$, and a power generation feature value $\alpha_b$ of the distributed power supply 21b is calculated as $\alpha_b = \Delta P_b/\Delta T = 0.30$.

At this time, for example, it is assumed that the pieces of power generation amount packet data D2a of the distributed power supply 21a at 16: 00 on February 6, 2019 and at 16: 01 on February 6, 2019 are given by the pieces of power generation amount packet data D2a-0 and D2a-1 of FIG. 3, respectively. At this time, the power generation feature value calculation unit 201 of FIG. 1 can calculate the feature value D3a of the distributed power supply 21a by using the pieces of power generation amount packet data D2a-0 and D2a-1 as the power generation amount packet data set.

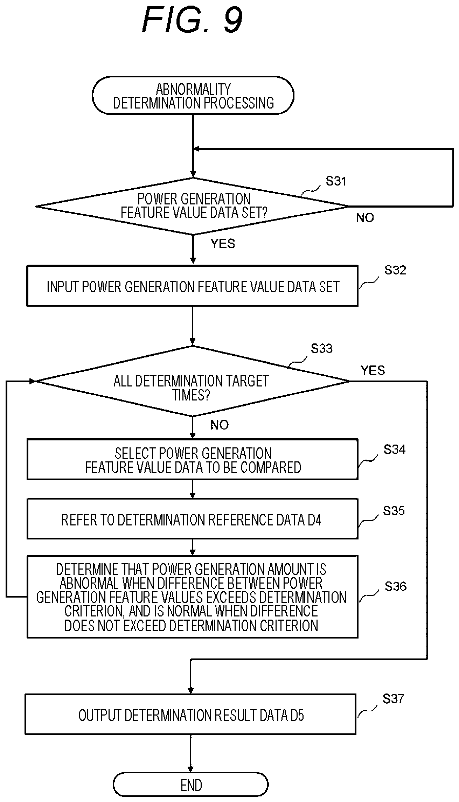

FIG. 9 is a flowchart illustrating an example of abnormality determination processing of FIG. 5.

In S31 of FIG. 9, the abnormality diagnosis unit 202 determines whether or not the power generation feature value data set is already obtained. The power generation feature value data set is data in which the power generation feature values of the plurality of distributed power supplies are set. The power generation feature value data set is, for example, a combination of the feature value D3a of the power generation amount of the distributed power supply 21a, the feature value D3b of the power generation amount of the distributed power supply 21b, and the feature value D3c of the power generation amount of the distributed power supply 21c in FIG. 4. When the abnormality diagnosis unit 202 does not already obtain the power generation feature value data set (S31: NO), the processing returns to S31, and when the abnormality diagnosis unit already obtains the power generation amount packet data set (S31: YES), the processing proceeds to S32.

Subsequently, in S32, the abnormality diagnosis unit 202 reads the power generation feature value data set from the storage 13 of FIG. 4 to the memory 12, for example.

Subsequently, in S33, the abnormality diagnosis unit 202 determines whether or not the determination results are calculated for all the determination target times. When the abnormality diagnosis unit 202 calculates the determination results for all the determination target times (S33: YES), the processing proceeds to S37. When the abnormality diagnosis unit 202 does not calculate the determination results for all the determination target times (S33: NO), the processing proceeds to S34.

Subsequently, in S34, the abnormality diagnosis unit 202 selects the power generation feature value data to be compared in any determination target time for which the determination result is not calculated.

Subsequently, in S35, the abnormality diagnosis unit 202 reads the abnormality reference data D4 from the storage 13 to the memory 12, for example.

Subsequently, in S36, the abnormality diagnosis unit 202 determines that the power generation amount of the distributed power supply is abnormal when an absolute value of the difference between the power generation feature values exceeds a determination reference for the determination target time of the power generation feature value data selected in S34, and determines that the power generation amount is normal when the absolute value does not exceed the determination reference.

For example, when a threshold value is $\varepsilon_1$ and the power generation feature values of the distributed power supplies 21a and 21b are $\alpha_a$ and $\alpha_b$, respectively, it is determined that one of the distributed power supplies 21a and 21b is abnormal when the following Equation (2) is satisfied, and it is determined that one of the distributed power supplies is normal when the following Equation (2) is not satisfied.

$$\left| \alpha_a - \alpha_b \right| > \varepsilon_1 \quad \dots \ (2)$$

For example, when $\alpha_a = 0.15$, $\alpha_b = 0.30$, and $\varepsilon_1 = 0.10$, the abnormality diagnosis unit 202 diagnoses that one of the distributed power supplies 21a and 21b is abnormal.

Alternatively, the abnormality determination may be performed by using two or more types of feature values. For example, a determination expression for comparing a weighted sum of absolute values of differences related to the plurality of feature values with the threshold value may be used. As an example, it is assumed that $\varepsilon_2$ is a threshold value of weighting and $\beta_a$ and $\beta_b$ are different feature values of the distributed power supplies 21a and 21b (for example, the ratios between the rated power generation amount and the power generation amounts), it may be determined that the distributed power supply is abnormal when the following Equation (3) is satisfied, and it may be determined that the distributed power supply is normal when the following Equation (3) is not satisfied.

$$\left| \alpha_a - \alpha_b \right| + \left| \beta_a - \beta_b \right| > \varepsilon_2 \quad \dots \ (3)$$

Subsequently, in S37, the abnormality diagnosis unit 202 outputs the determination result data D5. At this time, when the determination results are calculated by comparing the feature values of the plurality of distributed power supplies (distributed power supply 21b, 21c,...), the determination result with the larger total number may be calculated and output as comprehensive determination. An abnormality determination ratio and a determination result for each distributed power supply at each time may be indicated by comparing the total number of times the abnormality occurs on the day or the feature values of the plurality of distributed power supplies.

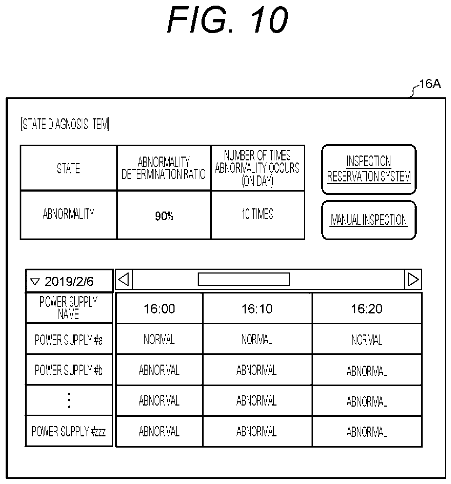

FIG. 10 is a diagram illustrating an example of a notification screen of a determination result displayed on the display unit of FIG. 1.

In FIG. 10, a notification screen 16A is displayed on a device having a display function, such as the display device 16 of FIG. 4. The notification screen 16A displays abnormality diagnosis result data D7 obtained by aggregating the determination result data D5. For example, the notification screen 16A can display whether each power supply is normal or abnormal at predetermined time intervals (For example, every 10 minutes), and can display the state of the target distributed power supply, the abnormality diagnosis ratio, and the number of times the abnormality occurs on the day. Accordingly, the data processing device 100 can transmit items necessary for recognizing the state of the measurement data of the target distributed power supply to a handler of the sensor data related to the distributed power supply.

As described above, according to the above-described embodiment, even when erroneous transaction data is generated due to a failure of a power generation amount meter in a transaction market of a kWh value that does not have power flow information of all power networks, it is possible to detect an abnormality in the power generation amount of the distributed power supply, and it is possible to improve the reliability of the power generation amount data of the distributed power supply used for non-kWh value transaction.

For example, as a power supply or a household electric device has an Internet of Technology (IoT) function, a simple meter that measures a power generation amount and a device having a communication function have been widely used, and thus, the measure of the simple meter widely used can be used as power generation amount data. When the power generation amount data of the simple meter is used for the non-kWh value transaction, it is possible to detect the occurrence of abnormal data during an operation of transaction data, and it is possible to immediately detect an abnormality in the power generation amount even when the abnormal data is mixed in normal data.

Although the embodiment of the present invention has been described above, the embodiment is merely an example for describing the present invention, and is not intended to limit the scope of the present invention to only the embodiment. The present invention can be executed in other various forms.

For example, the data processing device 100 may realize one or more of the power generation feature value calculation unit 201, the abnormality diagnosis unit 202, and the result output unit 203 by the software-defined device or the virtual device provided based on the computer resource pool (for example, the interface device unit, the storage unit, and the processor unit) such as the cloud infrastructure, and may determine the abnormality at a time for the plurality of distributed power supplies based on the pieces of power generation amount packet data regarding the pieces of power generation amount data D1 regarding the plurality of distributed power supplies.

Reference Signs List

| | |
|---|---|
| 100 | data processing device |
| 21a to 21c | distributed power supply |
| 22a to 22c | sensor |
| 23b, 23c | packet communication terminal |
| 200 | packet generation unit |
| 201 | power generation feature value calculation unit |
| 202 | abnormality diagnosis unit |
| 203 | result output unit |
| 206 | display unit |
| D1 | power generation amount data |
| D2 | power generation amount packet data |
| D3 | power generation feature value data |
| D4 | abnormality reference data |
| D5 | determination result data |
| D6 | identification data |

**Claims**

1. A data processing device comprising:

   a feature value calculation unit which calculates feature values of power generation amounts of distributed power supplies;
   a diagnosis unit that compares feature values of power generation amounts of N (N is an integer of 2 or more) distributed power supplies based on positions of the N distributed power supplies and measurement times of the power generation amounts, and diagnoses an abnormality in the power generation amount of the distributed power supply based on a comparison result.

2. The data processing device according to claim 1, further comprising:

   a generation unit which generates packet data in which information indicating the position of the distributed power supply and the measurement time of the power generation amount is added to power generation amount data of the power generation amount; and
   an output unit which outputs a diagnosis result of the abnormality in the power generation amount of the distributed power supply.

3. The data processing device according to claim 1, wherein the diagnosis unit diagnoses the abnormality in the power generation amount of the distributed power supply based on the comparison result of feature values of power generation amounts of distributed power supplies present within a predetermined range measured in a same time zone.

4. The data processing device according to claim 3, wherein the diagnosis unit determines similarity between the feature values of the power generation amounts of the N distributed power supplies based on a predetermined reference, and diagnoses the abnormality in the power generation amount of the distributed power supply based on the similarity.

5. The data processing device according to claim 3, wherein the feature values of the power generation amounts of the distributed power supplies are tendencies of changes in the power generation amounts of the distributed power supplies present within the predetermined range in the same time zone.

6. A data processing method executed by a processor, wherein

   the processor
   compares feature values of power generation amounts of N (N is an integer of 2 or more) distributed power supplies based on positions of the N distributed power supplies and measurement times of the power generation amounts, and

diagnoses an abnormality in the power generation amount of the distributed power supply based on the comparison result.

7. The data processing method according to claim 6, wherein

the processor

generates packet data in which information indicating the position of the distributed power supply and the measurement time of the power generation amount is added to power generation amount data of the power generation amount, and

outputs a diagnosis result of the abnormality in the power generation amount of the distributed power supply.

8. The data processing method according to claim 6, wherein the processor diagnoses the abnormality in the power generation amount of the distributed power supply based on a comparison result of feature values of power generation amounts of distributed power supplies present within a predetermined range measure in the same time zone.

9. The data processing method according to claim 8, wherein

the processor

determines similarity between the feature values of the power generation amounts of the N distributed power supplies based on a predetermined reference, and

diagnoses the abnormality in the power generation amount of the distributed power supply based on the similarity.

10. The data processing method according to claim 8, wherein the feature values of the power generation amounts of the distributed power supplies are tendencies of changes in the power generation amounts of the distributed power supplies present within the predetermined range in the same time zone.

# FIG. 1

# FIG. 2

# FIG. 3

D2a-0

| | 0.45kWh | RATED(kW):3, ID:#1 | lat:36.52.1 lng:140.60 | 2019/2/6 16:00 |
|---|---------|-------------------|------------------------|----------------|

D2a-

| | 0.6kWh | RATED(kW):3 , ID:#1 | lat:36.52.1 lng:140.60 | 2019/2/6 16:01 |
|---|--------|---------------------|------------------------|----------------|

# FIG. 4

EP 3 996 242 A1

# FIG. 5

```
    ┌─────────────────────────────┐
    │  ABNORMALITY DETERMINATION  │
    │   PRESENTATION PROCESSING   │
    └─────────────────────────────┘
                  │
                  ▼
    ┌─────────────────────────────┐
    │  PACKET GENERATION PROCESSING│  S1
    └─────────────────────────────┘
                  │
                  ▼
    ┌─────────────────────────────┐
    │ POWER GENERATION FEATURE VALUE│ S2
    │    CALCULATION PROCESSING    │
    └─────────────────────────────┘
                  │
                  ▼
    ┌─────────────────────────────┐
    │ ABNORMALITY DIAGNOSIS PROCESSING│ S3
    └─────────────────────────────┘
                  │
                  ▼
    ┌─────────────────────────────┐
    │     RESULT OUTPUT (DISPLAY)  │  S4
    └─────────────────────────────┘
                  │
                  ▼
    ┌─────────────────────────────┐
    │             END             │
    └─────────────────────────────┘
```

16

# FIG. 6

PACKET GENERATION PROCESSING

MEASUREMENT DATA? — S11
NO

YES

REFER TO IDENTIFICATION DATA — S12

ALL PIECES OF MEASUREMENT DATA? — S13
YES

NO

SELECT MEASUREMENT DATA — S14

GIVE IDENTIFICATION DATA AND POSITION DATA,
AND CREATE POWER GENERATION AMOUNT PACKET DATA — S15

OUTPUT POWER GENERATION AMOUNT PACKET DATA SET — S16

END

# FIG. 7

```
        ┌─────────────────────────┐
        │    FEATURE VALUE         │
        │  CALCULATION PROCESSING  │
        └─────────────────────────┘
                    │
                    ▼                              S21
            ◇─────────────────────◇
            POWER GENERATION AMOUNT  ───── NO ─────┐
              PACKET DATA SET?                      │
            ◇─────────────────────◇                │
                    │ YES                           │
                    ▼                     S22       │
        ┌─────────────────────────────────┐        │
        │ INPUT POWER GENERATION AMOUNT    │        │
        │      PACKET DATA SET             │        │
        └─────────────────────────────────┘        │
                    │                               │
                    ▼              S23              │
            ◇─────────────────────◇   YES
      ┌──── ALL DETERMINATION TARGET ──────────────────┐
      │          TIMES?                                 │
      │     ◇─────────────────────◇                    │
      │             │ NO                                │
      │             ▼                        S24        │
      │  ┌──────────────────────────────────────┐      │
      │  │ SELECT ANY DETERMINATION TARGET TIME  │      │
      │  │ IN WHICH POWER GENERATION FEATURE     │      │
      │  │ VALUE IS NOT CALCULATED               │      │
      │  └──────────────────────────────────────┘      │
      │             │                         S25       │
      │             ▼                                   │
      │  ┌──────────────────────────────────────┐      │
      │  │ SELECT DATA OF ANOTHER POWER SUPPLY    │     │
      │  │ IN SAME TIME ZONE AND IN CLOSE DISTANCE│     │
      │  └──────────────────────────────────────┘      │
      │             │                         S26       │
      │             ▼                                   │
      │  ┌──────────────────────────────────────┐      │
      └─ │ CALCULATE RATE OF CHANGE IN POWER      │     │
         │ GENERATION AMOUNT OF TARGET POWER      │     │
         │ SUPPLY IN TARGET TIME ZONE             │     │
         └──────────────────────────────────────┘      │
                    │                                   │
                    ▼ ◄─────────────────────────────────┘
                    │                        S27
        ┌─────────────────────────────────┐
        │ OUTPUT POWER GENERATION FEATURE  │
        │      VALUE DATA SET              │
        └─────────────────────────────────┘
                    │
                    ▼
              ┌──────────┐
              │   END    │
              └──────────┘
```

# FIG. 8

POWER GENERATION AMOUNT/
(RATED AND TIME WIDTH)
(kWh/kWh)

DISTRIBUTED POWER SUPPLY 21a

$P_a$

1

0.6

0.45

0

$\alpha_a$

$\Delta P_a$

$\Delta T$

2019/2/6
16:00

2019/2/6
16:01

TIME

POWER GENERATION AMOUNT/
(RATED AND TIME WIDTH)
(kWh/kWh)

DISTRIBUTED POWER SUPPLY 21b

$P_b$

1

0.75

0.45

0

$\alpha_b$

$\Delta P_b$

$\Delta T$

2019/2/6
16:00

2019/2/6
16:01

TIME

# FIG. 9

```
      ┌─────────────────────────────┐
      │        ABNORMALITY          │
      │  DETERMINATION PROCESSING   │
      └─────────────────────────────┘
                   │
                   ▼
            ╱─────────────╲                    S31
           ╱ POWER GENERATION ╲  NO
          ╱ FEATURE VALUE DATA SET? ╲──────────┐
           ╲                 ╱                 │
            ╲───────────────╱                  │
                   │ YES                       │
                   ▼                           │
  ┌──────────────────────────────────┐  S32    │
  │ INPUT POWER GENERATION FEATURE    │        │
  │        VALUE DATA SET             │        │
  └──────────────────────────────────┘        │
                   │                           │
                   ▼                           │
            ╱─────────────╲          S33        │
           ╱ ALL DETERMINATION ╲  YES           │
  ┌───────╱     TARGET TIMES?   ╲───────────┐   │
  │        ╲                 ╱              │   │
  │         ╲───────────────╱               │   │
  │                │ NO                      │   │
  │                ▼                         │   │
  │  ┌──────────────────────────────┐ S34    │   │
  │  │   SELECT POWER GENERATION     │       │   │
  │  │ FEATURE VALUE DATA TO BE      │       │   │
  │  │         COMPARED              │       │   │
  │  └──────────────────────────────┘       │   │
  │                │                         │   │
  │                ▼                         │   │
  │  ┌──────────────────────────────┐ S35    │   │
  │  │ REFER TO DETERMINATION         │       │   │
  │  │   REFERENCE DATA D4           │       │   │
  │  └──────────────────────────────┘       │   │
  │                │                         │   │
  │                ▼                         │   │
  │  ┌──────────────────────────────┐ S36    │   │
  │  │ DETERMINE THAT POWER GENERATION│       │   │
  │  │  AMOUNT IS ABNORMAL WHEN       │       │   │
  │  │  DIFFERENCE BETWEEN POWER      │       │   │
  │  │  GENERATION FEATURE VALUES     │       │   │
  │  │  EXCEEDS DETERMINATION         │       │   │
  │  │  CRITERION, AND IS NORMAL WHEN │       │   │
  │  │  DIFFERENCE DOES NOT EXCEED    │       │   │
  │  │  DETERMINATION CRITERION       │       │   │
  └──┤                              │       │   │
     └──────────────────────────────┘       │   │
                                             │   │
                   ┌─────────────────────────┘   │
                   ▼                             │
  ┌──────────────────────────────────┐  S37      │
  │  OUTPUT DETERMINATION RESULT       │         │
  │           DATA D5                  │         │
  └──────────────────────────────────┘         │
                   │                             │
                   ▼                             │
            ┌─────────────┐                     │
            │     END     │                     │
            └─────────────┘                     │
```

# FIG. 10

~16A

[STATE DIAGNOSIS ITEM]

| STATE | ABNORMALITY DETERMINATION RATIO | NUMBER OF TIMES ABNORMALITY OCCURS (ON DAY) |
|---|---|---|
| ABNORMALITY | 90% | 10 TIMES |

INSPECTION RESERVATION SYSTEM

MANUAL INSPECTION

| ▽ 2019/2/6 | ◁ | | ▷ |
|---|---|---|---|
| POWER SUPPLY NAME | 16:00 | 16:10 | 16:20 |
| POWER SUPPLY #a | NORMAL | NORMAL | NORMAL |
| POWER SUPPLY #b | ABNORMAL | ABNORMAL | ABNORMAL |
| ⋮ | ABNORMAL | ABNORMAL | ABNORMAL |
| POWER SUPPLY #zzz | ABNORMAL | ABNORMAL | ABNORMAL |

## INTERNATIONAL SEARCH REPORT

| International application No. |
|---|
| PCT/JP2020/025218 |

**A. CLASSIFICATION OF SUBJECT MATTER**
Int.Cl. H02J13/00(2006.01)i, H02J3/38(2006.01)i, F03D17/00(2016.01)n

According to International Patent Classification (IPC) or to both national classification and IPC

**B. FIELDS SEARCHED**

Minimum documentation searched (classification system followed by classification symbols)
Int.Cl. F03D17/00, G01R31/34, H02J3/38, H02J7/35, H02J13/00, H02S50/00

Documentation searched other than minimum documentation to the extent that such documents are included in the fields searched
Published examined utility model applications of Japan     1922–1996
Published unexamined utility model applications of Japan   1971–2020
Registered utility model specifications of Japan          1996–2020
Published registered utility model applications of Japan  1994–2020

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2002-95163 A (SHARP CORPORATION) 29.03.2002<br>(2002-03-29), paragraphs [0030]-[0077], fig. 1-12 | 1-4, 6-9<br>5, 10 |
| A | US 2011/0145277 A1 (GENERAL ELECTRIC CO.)<br>16.06.2011 (2011-06-16), whole document | 1-10 |
| A | JP 2018-91738 A (SEIKO EPSON CORPORATION)<br>14.06.2018 (2018-06-14), whole document | 1-10 |

☐ Further documents are listed in the continuation of Box C.     ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 09.09.2020 | 24.09.2020 |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
|---|---|

Form PCT/ISA/210 (second sheet) (January 2015)

**INTERNATIONAL SEARCH REPORT**

Information on patent family members

International application No.

PCT/JP2020/025218

```
JP 2002-95163 A      29.03.2002    JP 2005-168297 A
                                    IDEM
                                    JP 2010-207085 A
                                    IDEM
                                    JP 2011-147340 A
                                    IDEM
                                    JP 3817124 B2
                                    IDEM
                                    JP 5496782 B2
                                    IDEM
                                    JP 5496933 B2
                                    IDEM

US 2011/0145277 A1 16.06.2011      CN 102208050 A
                                    whole document
                                    EP 2372479 A1
                                    whole document
                                    US 8295987 B2
                                    whole document

JP 2018-91738 A      14.06.2018    (Family: none)
```

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018091738 A